Europäisches Patentamt

European Patent Office

Office européen des brevets

(11) Veröffentlichungsnummer: **0 162 960**
**A1**

(12) # EUROPÄISCHE PATENTANMELDUNG

(21) Anmeldenummer: **84115387.7**

(22) Anmeldetag: **13.12.84**

(51) Int. Cl.⁴: **H 05 K 7/20**

(30) Priorität: **27.04.84 DE 3415770**

(43) Veröffentlichungstag der Anmeldung:
**04.12.85 Patentblatt 85/49**

(84) Benannte Vertragsstaaten:
**BE CH DE FR IT LI SE**

(71) Anmelder: **Siemens Aktiengesellschaft
Berlin und München Wittelsbacherplatz 2
D-8000 München 2(DE)**

(72) Erfinder: **Modschiedler, Kurt
Langenbrucker Weg 3
D-8524 Neunkirchen(DE)**

(54) **Lüfteranordnung.**

(57) Bei einer Lüfteranordnung, die mehrere in einem Einschub (E) geführte Lüfter (L1, L2) aufweist, ist unterhalb des Bodens des Einschubs (E) ein wannenförmiger Filterrahmen (FR) vorgesehen, der zur Aufnahme eines Staubfilters (SF) dient. Dieses Staubfilter (SF) ist nach Schwenken un eine im rückwärtigen Bereich des Einschubs (E) angeordnete horizontale Achse zur Frontseite hin herausnehmbar.

FIG 2

EP 0 162 960 A1

Siemens Aktiengesellschaft    Unser Zeichen
Berlin und München           VPA **84 P 3 1 4 5** E

## Lüfteranordnung

Die Erfindung bezieht sich auf eine Lüfteranordnung, bei der mindestens ein einen vertikal aufsteigenden Luftstrom erzeugender Lüfter an einem mindestens eine Lufteintrittsöffnung aufweisenden Boden eines seitlich geführten, eine Frontabdeckung aufweisenden Einschubs für ein elektrisches Aufbausystem angeordnet ist.

Derartige Lüfteranordnungen sind als kompakte Mittel zur Kühlung des Innenraumes von elektrischen Aufbausystemen handelsüblich. Wenn beispielsweise beim Einsatz von derartigen Aufbausystemen in Industrieanlagen mit staubbelasteter Umgebungsluft zu rechnen ist, erweist es sich dabei als zweckmäßig, die Umgebungsluft durch ein Staubfilter zu führen. Staubfilter müssen jedoch in bestimmten Abständen ausgetauscht bzw. gereinigt werden, was jeweils mit einem gewissen Montageaufwand verbunden ist.

Aufgabe der Erfindung ist es, eine Anordnung der eingangs genannten Art so auszubilden, daß ein ausgesprochen schneller und leichter Wechsel von vorgesehenen Staubfiltern möglich ist.

Gemäß der Erfindung wird diese Aufgabe dadurch gelöst, daß unter dem Boden des Einschubs ein Filterrahmen zur Aufnahme eines Staubfilters vorgesehen ist, wobei der Filterrahmen um eine horizontale Achse im rückwärtigen Bereich des Einschubs schwenkbar ist und nach Überschreiten eines vorgegebenen Öffnungswinkels zur Front hin aus dem Einschub entriegelbar ist. Dadurch wird sichergestellt, daß während des Herausnehmens des Staubfilters

Woe 2 Bih / 24.04.1984

dieser mechanisch unbelastet bleibt und an ihm haftende Schmutzpartikel nicht in das Innere des Aufbausystems
fallen. Der Einschub muß dabei zur Demontage des Filterrahmens nicht völlig aus dem Aufbausystem entfernt
werden, sondern es reicht, wenn der Einschub teilweise
vorgezogen wird.

Dadurch, daß in der Arbeitsstellung des Filterrahmens
dieser mit Hilfe von Rastelementen in seiner Lage zum
Einschub fixierbar ist, ist es möglich, daß der Staubfilter ohne Zuhilfenahme von Werkzeug montiert und demontiert werden kann.

Wenn der Filterrahmen wannenförmig ausgebildet ist und
wenn das Staubfilter zwischen dem Wannenboden und dem
Boden des Einschubs verspannbar ist, wird sichergestellt, daß das Staubfilter sicher geführt wird, ohne
daß die Gefahr von Nebenluft gewährenden Durchlässen
besteht.

Der Raum oberhalb des Bodens des Einschubs und außerhalb des Bereichs der Lüfter kann einer elektrischen
Leiterplatte Raum geben. Auf dieser können beispielsweise
Steuerelemente für die Lüfter angeordnet sein. Eine derartig angeordnete elektrische Leiterplatte ermöglicht
dann, wenn die Lufteintrittsöffnungen der Lüfter in
Höhe der Leiterplatte befindlich sind, die Verwendung
eines Staubfilters, welches eine größere Fläche als
die Lufteintrittsfläche der Lüfter aufweist. Der Raum
zwischen den Lüftern und dem Staubfilter dient dann als
Ausgleichskammer.

Ein Ausführungsbeispiel der Erfindung ist in der Zeichnung dargestellt und wird im folgenden näher erläutert.

Dabei zeigen:

Fig. 1 eine perspektivische Darstellung einer Lüfteranordnung,

Fig. 2 im Schnitt eine Lüfteranordnung mit montiertem
Staubfilter und

Fig. 3 eine Lüfteranordnung mit in Demontage befindlichem Staubfilter.

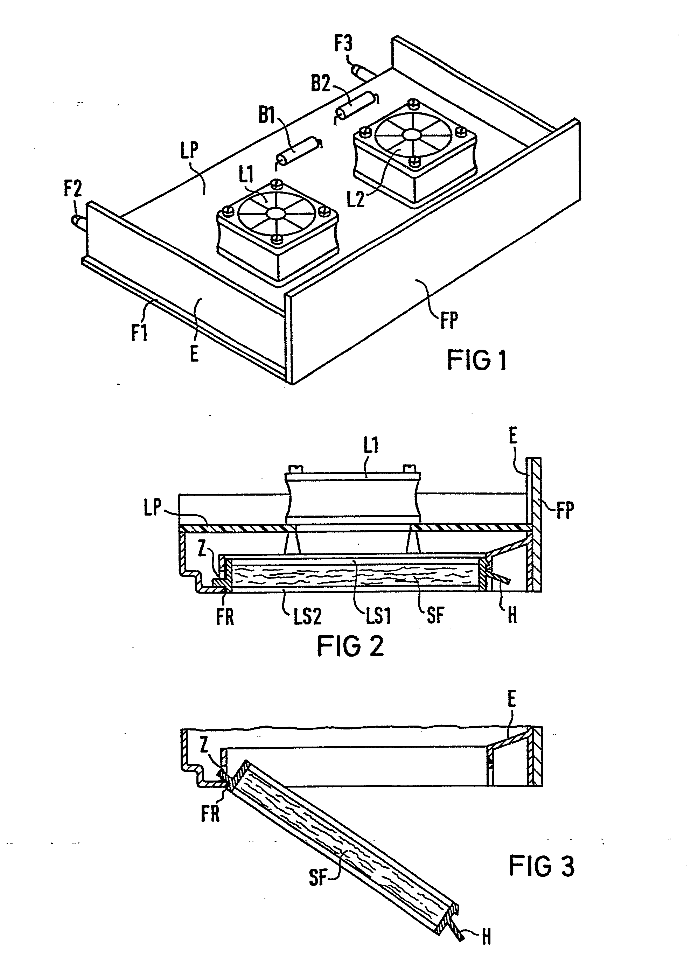

In der Darstellung gemäß Fig.1 ist perspektivisch ein Einschub E gezeigt, der in ein der Übersichtlichkeit halber nicht dargestelltes elektrisches Aufbausystem einschiebbar ist. Der Einschub E wird mit Hilfe von an den Seiten des Einschubs E angebrachten Führungen gelenkt, von denen der Übersichtlichkeit halber nur die linke Führung F1 gezeigt ist. Eine Zentrierung des Einschubs E erfolgt mit Hilfe zweier rückwärtiger zusätzlicher Führungen F2 und F3. Frontseitig weist der Einschub E eine diesen abdeckende Frontplatte FP auf, an der beliebige, der Übersichtlichkeit halber nicht dargestellte Bedien- und Kontrollelemente angeordnet sein können.

Der Einschub E trägt zwei Lüfter L1 und L2, die einen vertikal aufsteigenden Luftstrom erzeugen. Seitlich neben den Lüftern L1 und L2 ist eine waagrechte Leiterplatte LP vorgesehen, die mit beliebigen elektrischen Bauelementen bestückt sein kann, von denen nur die Bauelemente B1 und B2 dargestellt sind. Am rückwärtigen Teil der Leiterplatte LP bzw. des Einschubs E wäre es auch möglich, beliebige Kontaktelemente vorzusehen. Ferner wäre es auch möglich, beispielsweise Kühlkörper in diesen Bereich anzuordnen.

In der Darstellung gemäß Fig.2 ist ein Schnittbild der Anordnung gemäß Fig.1 gezeigt, wobei der Schnitt im Be-reich des Lüfters L1 erfolgt ist. Die Darstellung zeigt, daß der Einschub E, der den Lüfter L1 und die Leiter-

platte LP trägt und der frontseitig mit der Frontplatte FP versehen ist, unterhalb der Leiterplatte LP einen eingeformten Boden aufweist, wobei in diese Einformung ein wannenförmiger Filterrahmen FR als Träger eines Staubfilters SE einsetzbar ist. Der wannenförmige Filterrahmen FR weist dazu eine Zapfenanordnung Z auf, die in Ausnehmungen am rückwärtigen Teil des eingeformten Bodens des Einschubs E einsetzbar sind, so daß durch die Zapfen Z und die korrespondierenden Ausnehmungen ein Gelenk gebildet wird, das eine waagrechte Achse aufweist.

Dieses Gelenk ist dann, wenn der Filterrahmen FR, wie in Fig.3 abschnittsweise gezeigt, ausgeschwenkt wird, lösbar, so daß der Filterrahmen FR samt den in diesem befindlichen Staubfilter SF zur Frontseite hin vorgezogen werden kann. Das Schwenken des Filterrahmens FR erfolgt dabei mit Hilfe einer Handhabe H, die nach Hintergreifen der Frontplatte FP des vorgezogenen Einschubs E greifbar ist. Die Position von Filterrahmen FR zu Einschub E kann im geschlossenen Zustand, wie dieser in Fig.2 dargestellt ist, mit Hilfe von Rastelementen, die der Übersichtlichkeit halber nicht gezeigt sind, fixiert werden.

Oberhalb des Staubfilters SF befinden sich im Einschub E Luftschlitze LS1. In entsprechender Weise befinden sich Luftschlitze LS2 am Boden des wannenförmigen Filterrahmens FR.

5 Patentansprüche
3 Figuren

Patentansprüche

1. Lüfteranordnung, bei der mindestens ein einen vertikal aufsteigenden Luftstrom erzeugender Lüfter an einem mindestens eine Lufteintrittsöffnung aufweisenden Boden eines seitlichen geführten eine Frontabdeckung aufweisenden Einschubs für ein elektrisches Aufbausystem angeordnet ist, d a d u r c h   g e k e n n - z e i c h n e t ,   daß unter dem Boden des Einschubs (E) ein Filterrahmen (FR) zur Aufnahme eines Staubfilters (SF) vorgesehen ist, wobei der Filterrahmen (FR) um eine horizontale Achse im rückwärtigen Bereich des Einschubs (E) schwenkbar ist und nach Überschreiten eines vorgegebenen Öffnungswinkels zur Front hin aus dem Einschub (E) entriegelbar ist.

2. Lüfteranordnung nach Anspruch 1,   d a d u r c h   g e k e n n z e i c h n e t ,   daß in der Arbeitsstellung des Filterrahmens (FR) dieser mit Hilfe von Rastelementen in seiner Lage zum Einschub (E) fixierbar ist.

3. Lüfteranordnung nach Anspruch 1 oder 2, d a d u r c h   g e k e n n z e i c h n e t ,   daß der Filterrahmen (FR) wannenförmig ausgebildet ist und daß das Staubfilter (SF) zwischen dem Wannenboden und dem Boden des Einschubs (E) verspannbar ist.

4. Lüfteranordnung nach Anspruch 1, 2 oder 3,   d a - d u r c h   g e k e n n z e i c h n e t ,   daß oberhalb des Bodens des Einschubs (E) außerhalb des Bereiches der Lüfter (L1, L2) eine elektrische Leiterplatte (LP) vorgesehen ist.

5. Lüfteranordnung nach Anspruch 4, d a d u r c h
g e k e n n z e i c h n e t , daß die Lufteintrittsöffnungen der Lüfter (L1, L2) in Höhe der Leiterplatte
(LP) befindlich sind.

0162960

**FIG 1**

**FIG 2**

**FIG 3**

**EUROPÄISCHER RECHERCHENBERICHT**

Europäisches
Patentamt

EP 84 11 5387

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE-A-2 201 362 (D. GÄRTNER) * Insgesamt * | 1 | H 05 K 7/20 |
| A | DE-A-2 235 564 (PAPST-MOTOREN) * Insgesamt * | 1 | |
| A | FR-A-2 249 571 (INTERMAT-FRANCE) * Seite 2, Zeile 32 - Seite 3, Zeile 7; Figuren 1,2 * | 3 | |
| A | EP-A-0 089 401 (SIEMENS-ALBIS) * Insgesamt * | | |
| A | DESIGN ENGINEERING, Januar 1983, Seiten 73-80, London, GB; "Cooling electronic equipment" | | RECHERCHIERTE SACHGEBIETE (Int. Cl.4) H 05 K F 24 F B 01 D |

Der vorliegende Recherchenbericht wurde für alle Patentansprüche erstellt.

| Recherchenort DEN HAAG | Abschlußdatum der Recherche 23-07-1985 | Prüfer SCHRIJVERS H.J. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03 82